# EUROPEAN PATENT SPECIFICATION

(11) **EP 1 102 391 B1**
(45) Date of publication and mention of the grant of the patent: **04.06.2003**
(21) Application number: 00123957.3
(22) Date of filing: 03.11.2000
(51) Int. Cl.: H03B 5/36, H03B 5/04, H03L 3/00

(54) **Piezoelectric oscillator and electronic device using it**
Piezoelektrischer Oszillator und Vorrichtung mit einem derartigen Oszillator
Oscillateur piézo-électrique et dispositif électronique avec un tel oscillateur

(30) Priority: 18.11.1999 JP 32879299
(43) Date of publication of application: 23.05.2001
(73) Proprietor: SEIKO EPSON CORPORATION, Shinjuku-ku, Tokyo 163-0811 (JP)
(72) Inventor: Fujii, Yoichi, Suwa-shi, Nagano-ken 392-8502 (JP); Endo, Takashi, Suwa-shi, Nagano-ken 392-8502 (JP)
(74) Representative: Hoffmann, Eckart, Dipl.-Ing.

(56) References cited:
- US-A- 5 126 695
- US-A- 5 568 100
- PATENT ABSTRACTS OF JAPAN vol. 009, no. 022 (M-354), 30 January 1985 (1985-01-30) & JP 59 169301 A (HITACHI SEISAKUSHO KK), 25 September 1984 (1984-09-25)
- PATENT ABSTRACTS OF JAPAN vol. 007, no. 148 (E-184), 29 June 1983 (1983-06-29) & JP 58 060806 A (TOKYO SHIBAURA DENKI KK), 11 April 1983 (1983-04-11)

## Description

The present invention relates to a piezoelectric oscillator and an electronic device using it.

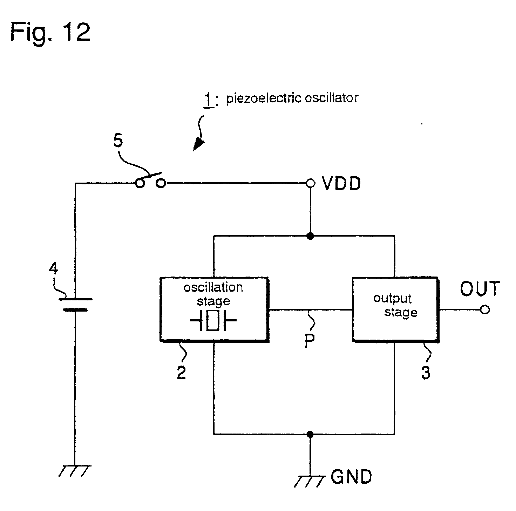

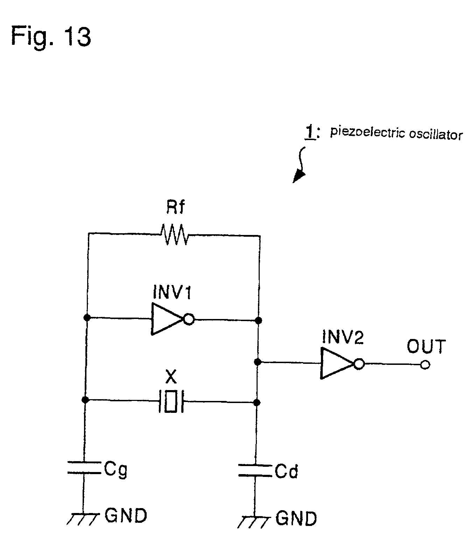

FIG. 12 is a block diagram of a conventional piezoelectric oscillator 1 used for an electronic device. A power source 4 is connected via a switch 5 to a power supply terminal VDD and ground GND of oscillator 1. As shown in Figs. 12 and 13, oscillator 1 is made up of an oscillation stage 2, which comprises a colpitts oscillation circuit consisting of a piezoelectric resonator X, an inverter INV1 for oscillation, a feedback resistor Rf, a capacitor Cg on the gate side, and a capacitor Cd on the drain side, and an output stage 3, which is an inverter INV2 for outputting the oscillation signal. Another conventional piezoelectric oscillator connected to an output stage for amplifying is known from document US 5 126 695 A.

Oscillator 1 outputs oscillation pulses P, generated by the oscillation stage 2, through the output stage 3 to an output terminal OUT of the oscillator 1 to which an external load is to be connected. Output stage 3 serves to maintain the oscillation stability and avoid frequency deviations of pulses P by preventing the external load from influencing the oscillation stage 2; at the same time, pulses P can be amplified by the output stage 3 to a level suitable for driving the external load.

In order to minimize spurious oscillation modes, it is generally preferable to excite the resonator X by low driving power in a range sufficient to maintain oscillation. Therefore, the driving power for the inverter INV1 is relatively low.

On the other hand the output stage 3 of the oscillator 1 needs to amplify the pulses P to the level suitable for driving the external load, so that the inverter INV2 requires more driving power than inverter INV1.

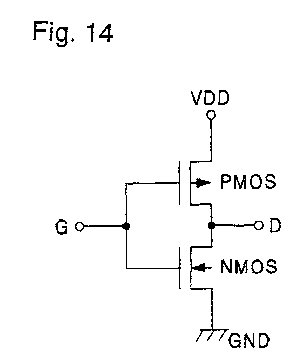

FIG. 14 is an example of a circuit structure usable for inverter INV1 and inverter INV2. As shown in FIG. 14, the inverter circuit comprises a series connection of a PMOS transistor and an NMOS transistor with one end of the PMOS transistor connected to a power source terminal VDD and one end of the NMOS transistor connected ground GND; the common gate of the PMOS transistor and the NMOS transistor forms the input G of the inverter and the node at which the respective other ends of the two transistors are connected together is the output D.

When power is applied to the oscillator 1, a through-current proportional to the driving power of the respective inverter instantaneously flows to the inverters INV1 and INV2. As mentioned above, the inverter INV2 has more driving power, so that the through-current to the inverter INV2 is relatively large, causing noise (referred to as power noise hereinafter) being generated during the transient state immediately after the power was supplied to the oscillator 1.

The power noise caused by the inverter INV2 prevents the inverter INV1 from starting stably, thereby resulting in an abnormal oscillation or no oscillation at all of the oscillation stage 2.

It is an object of the present invention to provide a piezoelectric oscillator in which the power noise during the transient period is reduced so as to stabilize the starting properties and to improve the oscillation stability; another object of the invention is to provide an electric device using this oscillator. A further advantage of the invention is to provide an oscillator which is adaptable to means for amplifying having a selectable driving power.

These objects are achieved with an oscillator as claimed in claim 1 and an electric device as claimed in claim 16, respectively. Preferred embodiments of the invention are subject-matter of the dependent claims.

Preferred embodiments of the invention will be explained below with reference to the drawings, in which:
- FIG. 1: is a block diagram of an oscillator according to a basic embodiment of the present invention;
- FIG. 2: shows the circuit configuration of the output stage and the start delay circuit;
- FIG. 3: illustrates an example of a clocked gate;
- FIG. 4: is a truth table of the clocked gate;
- FIG. 5: is a diagram for explaining the setting of the delay time;
- FIG. 6 to 11: are block diagrams of respective oscillators according modified embodiments of the invention;
- FIG. 12: is a block diagram of a conventional piezoelectric oscillator for use in an electronic device;
- FIG. 13: illustrates the circuit structure of the oscillator; and
- FIG. 14: shows the circuit structure of an inverter used for the oscillation stage and the output stage.

### (1) First Embodiment

### (1-1) Configuration of Embodiment

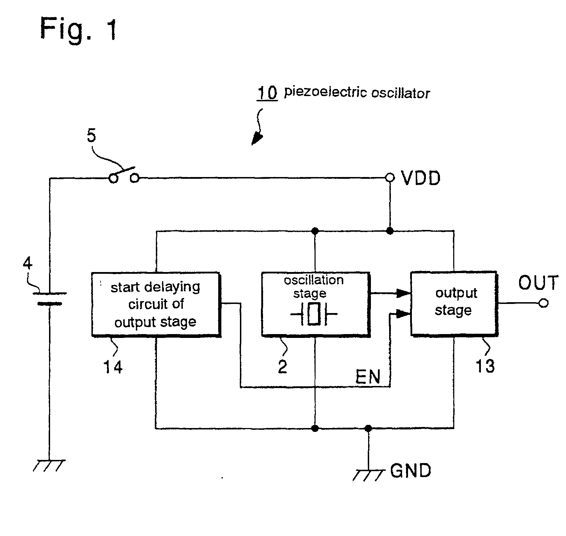

The piezoelectric oscillator 10 illustrated in Fig. 1 has the same structure as the oscillator 1 explained above, except that the configuration of the output stage 13 is different and a start delay circuit is added so as to delay the start of the output stage 13. Hence, the same reference numerals are used for identical parts and those parts will not be explained again.

### (1-1-1) Output Stage

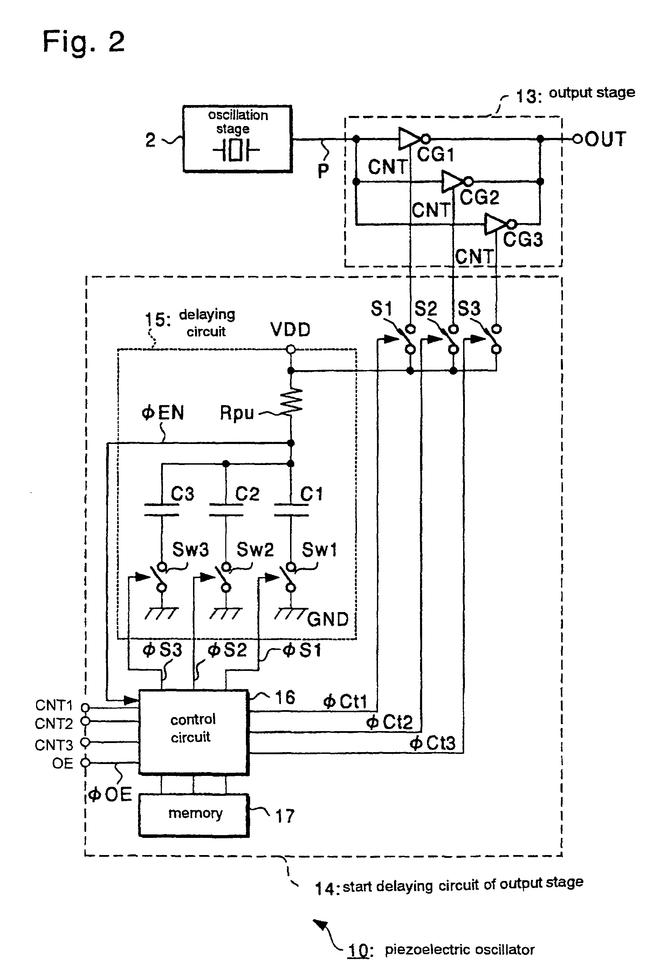

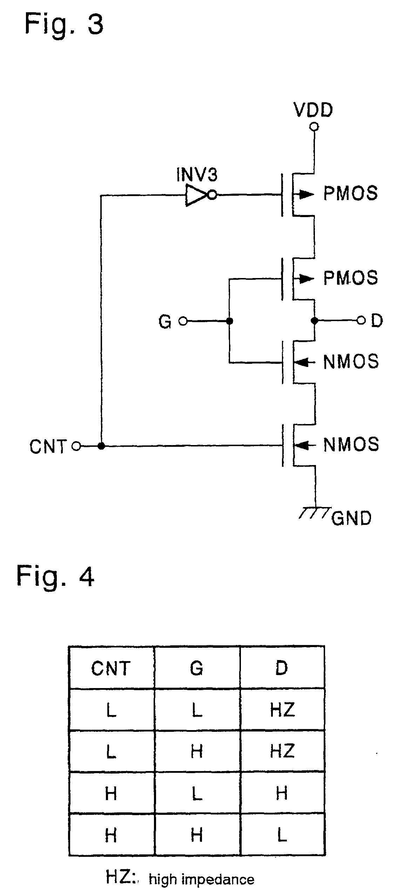

FIG. 2 shows the circuit configurations of the output stage 13 and the start delay circuit 14 in more detail. The output stage 13 comprises a parallel connection of three clocked gates CG1, CG2 and CG3. As shown in FIG. 3, the clocked gates are each formed of a first and a second PMOS transistor and a first and a second NMOS transistors having their source-drain-paths connected in series in this order between a power source terminal VDD and ground. The common gate of the second PMOS transistor and the first NMOS transistor is the input G of the clocked gate and the node between the source-drain-paths of these two transistors is the output D. A control input CNT is connected to the gate of the second NMOS transistor and, via an inverter INV3, to the gate of the first PMOS transistor.

FIG. 4 shows the truth table of the clocked gate. When control input CNT is at a high level (H), the input signal at input G is inverted at the output D. When the control input CNT is at the low level (L), the output D is in a so-called high impedance state regardless of the level at input G. In other words, in response to the signal level at the control input CNT the clocked gate switches between an operational state where it operates as a normal inverter and a non-operational state where its output practically becomes open.

As shown in FIG. 2, the output stage 13 adds the output pulses from those of the clocked gates CG1 to CG3 whose control input CNT is at a high level, and outputs these added output pulses as pulses P. As a result, the amplification factor of the output stage 13 as a whole, and, if the output stage 13 is considered to be one (equivalent) inverter IN, the driving power of this inverter change depending on the number of clocked gates whose control input CNT is at a high level.

While the clocked gates have been described as being made up of MOS transistors they may be made up of bipolar transistors.

### (1-1-2) Start Delay Circuit of Output Stage

The start delay circuit of output stage 13 consists of a delay circuit 15 for outputting a start signal φEN, three switches S1, S2 and S3, and a control circuit 16 for controlling the delay circuit 15 and the switches S1 to S3. Each of the switches has one end connected to the control input CNT of a respective one of the clocked gates CG1 to CG3; the respective other ends of the switches are commonly connected to the power source terminal VDD.

The delay circuit 15 consists of a pull-up resistor Rpu having one end connected to the power source terminal VDD, and a parallel circuit of three series connections between the other end of the resistor and ground. Each of the series connections comprises a respective one of three capacitors C1, C2 and C3 and a respective one of three switches Sw1, Sw2 and Sw3. The start signal φEN is taken off the node between the pull-up resistor Rpu and the parallel circuit and is applied to the control circuit 16.

When the power supply is switched on, the level of start signal φEN gradually increases in accordance with the time constant determined by the resistance of the pull-up resistor Rpu and the capacity of the parallel circuit between the resistor and ground. The capacity of the parallel circuit in turn is equal to the sum of the capacities of that or those of capacitors C1 to C3 whose associated switch Sw1, Sw2, and Sw3, respectively, is in the ON state. As a result, the delay circuit 15 can delay the moment at which the start signal φEN becomes a high-level signal relative to the moment at which the power supply is turned on by a delay time τ that depends on the connection/disconnection of the switches Sw1 to Sw3.

Therefore, when the capacities of the capacitors C1 to C3 are the same, one of three different time constants and, thus, one of three different delay times τ can be set in accordance with the number of switches Sw1 to Sw3 held in the ON state. Correspondingly, when the capacities of the capacitors C1 to C3 differ from one another, one of 3²-1 = 8 different delay times τ can be set in this embodiment using three series connections C1/Sw1, C2/Sw2 and C3/Sw3.

Since one end of each switch S1 to S3 is connected to the power source terminal VDD as described above, a high level signal is supplied to the control input CNT of that or those of the clocked gates CG1 to CG3 whose associated switch is in the ON state. When one or more predetermined ones of switches S1 to S3 are turned ON after the power supply has been switched on, the output stage 13 starts amplifying and outputting pulses P and the driving power depends on the number of ON state switches among switches S1 to S3.

By controlling the switches S1 to S3 and the switches Sw1 to Sw3 of the delay circuit 15, the control circuit 16 operates to control the delay circuit 15 and the output stage 13. In other words, when power is supplied from the power source terminal VDD, the control circuit 16 controls the connecting state of switches Sw1 to Sw3 by outputting control signals φS1, φS2 and φS3 to the switches Sw1 to Sw3, respectively, based on set data, which was pre-stored in memory 17. In this way, the control circuit 16 can set the delay time τ.

When start signal φEN has a high level, the control circuit 16 outputs control signals φCt1, φCt2 and φCt3 to the switches S1 to S3, respectively, based on the set data which was pre-stored in the memory 17, thus turning ON a predetermined number of switches. As a result, the control circuit 16 sets the driving power of the output stage 13, and at the same time, the output stage 13 starts operating.

Hence, when the power supply is turned on, the control circuit 16 sets the delay time τ for the start signal φEN based on predetermined set data, and starts the output stage 13 with a predetermined driving power when the delay time τ is over. In other words, with the oscillator 10, the output stage 13 is started, delayed by a predetermined delay time τ relative to the oscillation stage 2, which starts right after the power supply is turned on.

The control circuit 16 has input terminals CNT1, CNT2 and CNT3 for inputting set data, and another input terminal OE for inputting a stop signal φOE for stopping operation of the output stage 13. More specifically, when set data is input through the input terminals CNT1 to CNT3, the set data stored in the memory 17 is renewed to the set data thus supplied. As a result, oscillator 10 allows changing the delay time τ as well as changing the driving power of the output stage 13. While the set data for controlling the switches Sw1 to Sw3 and the switches S1 to S3 are shown to be input as parallel data via the three input terminals CNT1 to CNT3, there may be just one input terminal for inputting set data as serial data.

When the stop signal φOE is applied to input terminal OE after the start of the output stage 13, the control circuit 16 stops the operation of the output stage 13 by turning the switches S1 to S3 off. Therefore, the oscillator 10 can be made to stop outputting the pulses P at any desirable timing determined by the user of the oscillator 10.

US 5 568 100 A discloses an oscillator connected to an output stage driven by a start-delay means. But there the delay time is fixed.

### (1-2) Setting of Delay Time τ

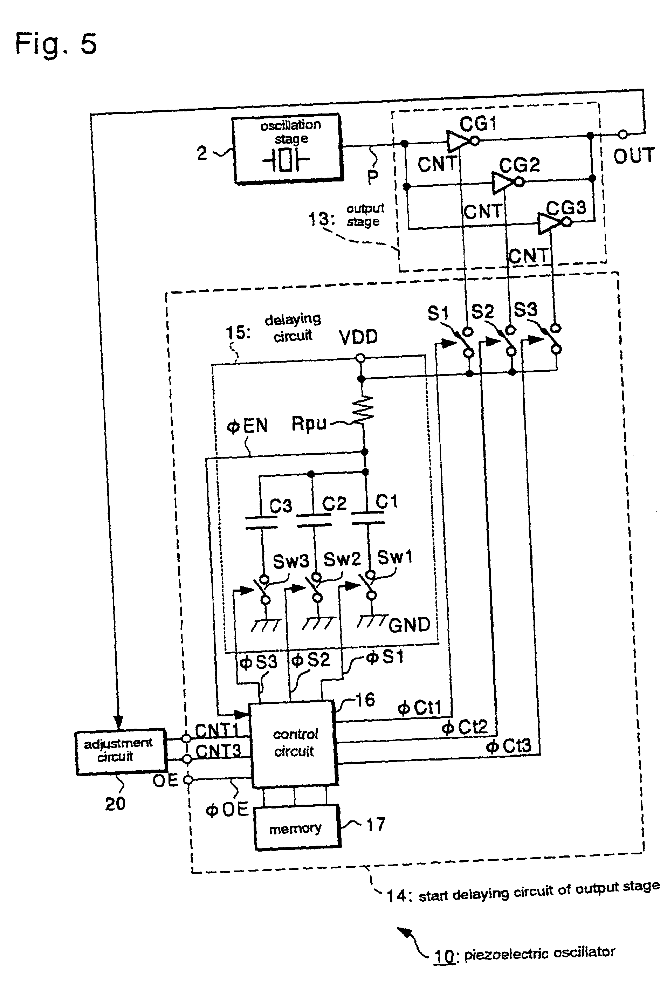

Setting an appropriate delay time τ for the start of the output stage 13 is explained below with reference to FIG. 5.

First, data is set at an adjustment circuit 20 so as to set the ON/OFF state for each of the switches S1 to S3 and Sw1 to Sw3 by operating the external adjustment circuit 20. The switches S1 to S3 are principally set so as to obtain the driving power necessary for the output stage 13.

The ON/OFF states of the switches Sw1 to Sw3, in other words, the delay time τ, should be set so that the output stage 13 starts operating at a time at which the oscillation of the oscillation stage 2 has stabilized and is no longer affected by the power noise generated when the output stage 13 starts operating. Therefore, the delay time τ must be established corresponding to the starting properties of the inverter INV1 of the oscillation stage 2, the driving power of the output stage 3 and the like. Thus, which of the switches Sw1 to Sw3 is to be turned on, is appropriately confirmed depending on whether there is any abnormal oscillation or no oscillation at all, while the output signal of the oscillator 10 is being monitored.

As soon as the power supply for the oscillator 10 is turned on, the set data stored or set in adjustment circuit 20 is supplied to the control circuit 16 through the terminals CNT1 to CNT3, thus overwriting set data in memory 17, if any. By thus supplying new set data to the control circuit 16 as soon as the power is turned on, the set data in memory 17 can be renewed to new set data before the oscillation stage 2 starts oscillating. The starting property of the oscillator 10, based on new set data, can then be monitored immediately. Moreover, set data can be recorded in memory 17 before the oscillation stage 2 starts oscillating; thus, even if no set data have yet been recorded in the memory 17, a malfunction of the oscillator 10 caused by a lack of set data can be avoided.

Then, based on the monitored results obtained by the set data from the adjustment circuit 20, oscillation frequencies of output signals at the beginning of oscillation are measured. When there is abnormal oscillation or no oscillation, the set data for the switches Sw1 to Sw3 is reset at the adjustment circuit 20 and the above-noted operation is repeated until finally, there is no longer any abnormal oscillation or no oscillation and the like of the output signal of the oscillator 10. At the same time, it is confirmed that the oscillator 10 has gained stable starting properties, and the setting of delay time τ is finished.

Thus, out of multiple candidate delay times the appropriate delay time can be selected and set.

The memory 17 of the control circuit 16 may be a non-volatile memory, which can be written only once. In this case, in setting the delay time τ, the control circuit 16 controls switches Sw1 to Sw3 based on the set data kept at the adjustment circuit 20, instead of the set data stored in memory 17. After an appropriate delay time τ has been established, corresponding set data is recorded in the memory 17, thus setting the appropriate delay time τ.

### (1-3) Efficacy of the Embodiment

The oscillator 10 according to the present embodiment starts the output stage 13 later than the oscillation stage 2 by a predetermined delay time τ, so that the starting property of the oscillation stage 2 can be stabilized by avoiding power noise being generated at the output stage 13 while the oscillation stage starts oscillating; hence, the oscillation stability of oscillation pulse can be improved.

Moreover, the output stage 13 is configured by connecting a plurality of clocked gates in parallel, so that the driving power of the output stage 13 can be selected among multiple values as desired by the user. Thus, there is no need to prepare different oscillators for different needs as with conventional oscillators, since oscillator 10 can be adapted to various user needs.

### (2) Modified Embodiments

### (2-1) First Modified Embodiment

In the description of the above-mentioned basic embodiment, three series connections, i.e., three pairs of capacitor and switch are provided to change the delay time τ of the delay circuit 15. However, the present invention is not limited to this case. The number of such pairs of capacitor and switch may be increased or decreased depending on the necessary number of candidate delay times. Moreover, the number of clocked gates, constituting the output stage 13, may also be increased or decreased. In this case, the number of switches for controlling the clocked gates would be increased or decreased correspondingly.

### (2-2) Second Modified Embodiment

In the above-noted basic embodiment, the delay circuit 15 consists of one pull-up resistor Rpu, a plurality of capacitors C1 to C3, and switches Sw1 to Sw3. However, the present invention is not limited to this case, and can broadly apply circuits, whose time constants change in response to the connection state of one or more switches.

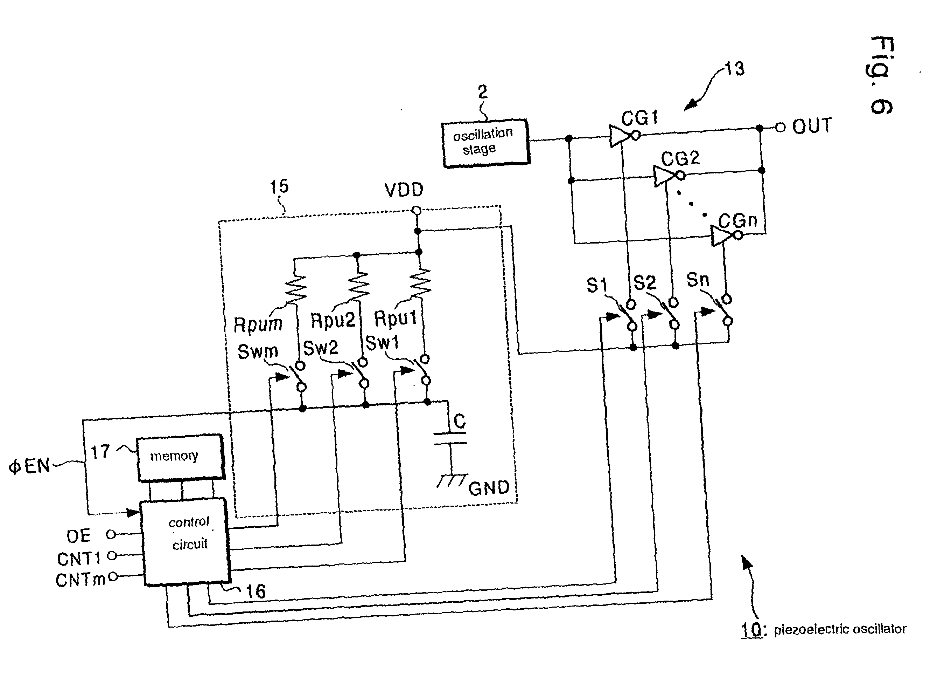

For instance, as shown in FIG. 6, the delay circuit 15 may be a circuit, which is made up of one capacitor C, m pull-up resistors Rpuj (j = 1, 2, ..., m), and m switches Swj. Resistor Rpuj and switch Swj are connected in series, and m such series connections are connected in parallel between the power source terminal VDD and one end of capacitor C whose other end is connected to ground GND.

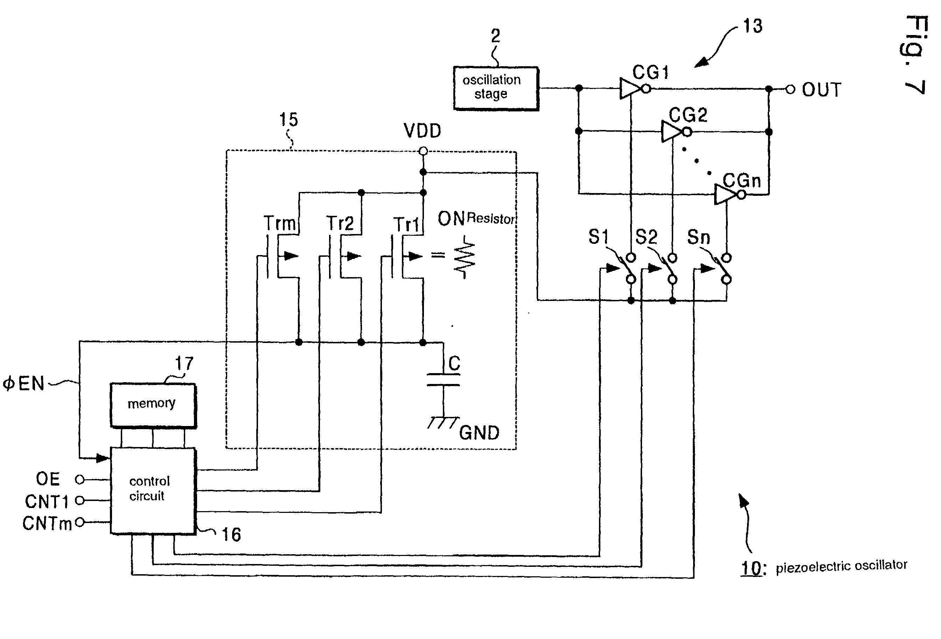

Furthermore, as shown in FIG. 7, each series connection Rpuj/Swj may be replaced by a PMOS transistors Trj (j = 1, 2, ..., m); in this case, the ON resistance of each PMOS transistor Trj is used as pull-up resistance Rpuj. Hence, with this modification the number of elements of the delay circuit 15 may be reduced, and the circuit configuration may be simplified.

### (2-3) Third Modified Embodiment

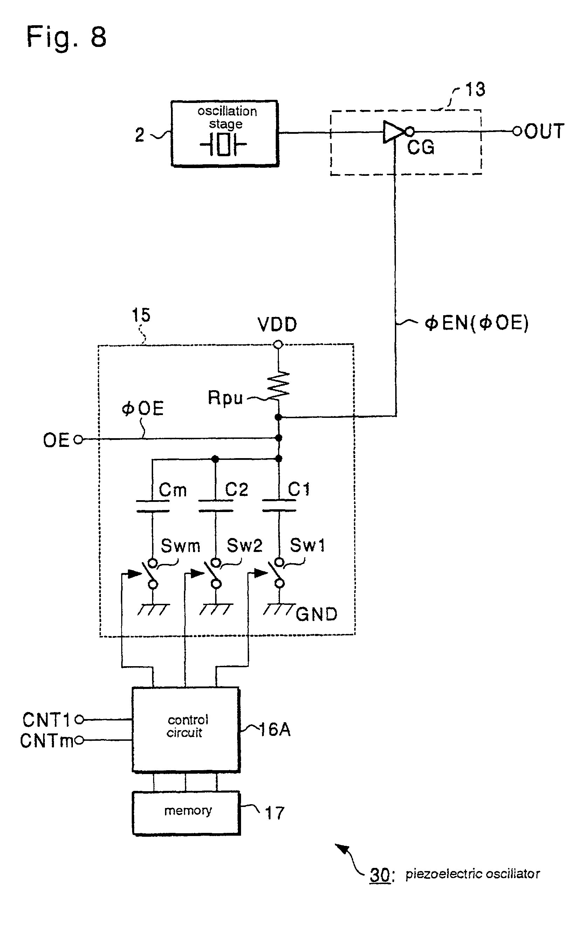

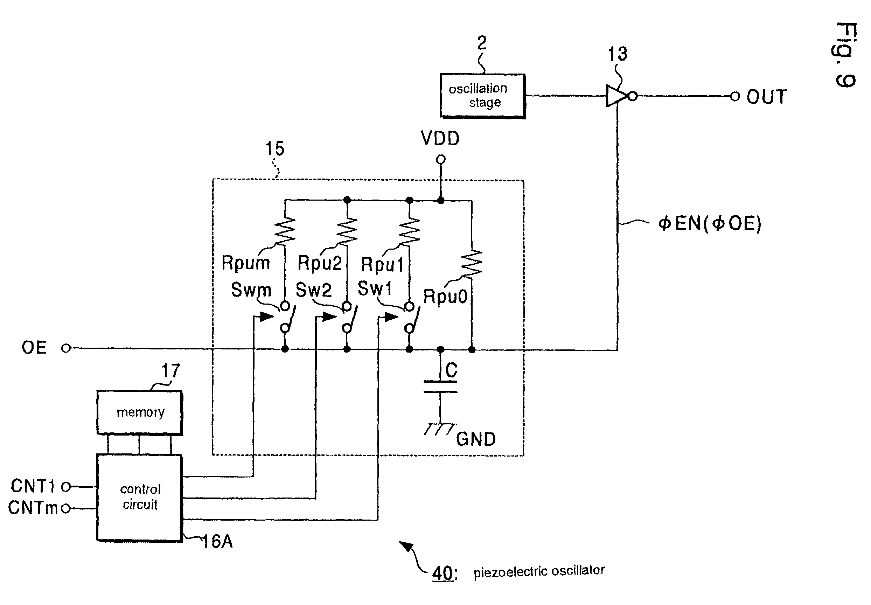

In the above-noted embodiments, the control circuit 16 starts the output stage 13 by means of switches S1 to S3, but the present invention is not limited to this case. For instance, as in the piezoelectric oscillators 30 and 40 shown in FIG. 8 and FIG. 9, start signal EN may be supplied to the control input CNT of each clocked gate of the output stage 13 so as to directly start the output stage 13 by the start signal φEN.

FIG. 9 is a circuit diagram of oscillator 40 in which the output stage 13 is controlled directly by the start signal φEN and the stop signal φOE, wherein the delay circuit 15 has the same structure as that in the second modified embodiment of Fig. 6.

Moreover, when the output stage 13 is directly started by the start signal φEN, the control circuit should maintain the switches (corresponding to S1 to Sn in Fig. 1 but not shown in this simplified example) connected to control input CNT of the clocked gates in the number corresponding to obtain the necessary driving power for the output stage 13, in the ON state before the output stage 13 is started.

Thus, for instance, a configuration can be considered wherein the switches of the delay circuit 15 and the switches connected to the control inputs CNT of the clocked gates of the output stage 13 correspond to each other, and a switch connected to the control input CNT of the corresponding clocked gate, will be turned ON when the switch of the delay circuit 15 is turned ON.

When a selection among multiple driving power values of the output stage 13 is not required, as shown in FIG. 8 and FIG. 9, in other words, when a single or all of a plurality of clocked gates constituting the output stage 13 are either in the normal operating state or the high impedance state, start signal φEN and stop signal φOE may be directly supplied to the clocked gates. In this case, the control circuit 16A is only to control the switches of the delay circuit 15, and the configuration of the control circuit 16A may be simplified.

Additionally, when the output stage 13 is directly controlled to stop operating by the stop signal φOE as with the oscillator 30 shown in FIG. 8, it is preferable to turn OFF all the switches of the delay circuit 15 after the oscillator 30 is completed to oscillate or has reached a steady state, in order to make the response to the stop signal φOE faster.

Moreover, if the stop signal φOE is directly supplied to the output stage 13 through the input terminal OE, a resistor for setting the electric potential of the terminal OE is necessary so as to avoid the potential from floating when the circuit providing the signal φOE is in the open state. The pull-up resistor Rpu is used as such resistor in the embodiment of FIG. 8. Since, in the embodiment of FIG. 8, the output stop signal φOE and the start signal φEN are applied to the same control input terminal of output stage 13, the pull-up resistor Rpu prevents the potential at input terminal OE from floating and no additional resistor is required.

Also, as the combined resistance of Rup0 and those of the pull-up resistors Rpuj that are connected by a respective switch Swj in an ON state, is small with the oscillator 40 shown in FIG. 9, the pull-up capability, in other words, the stability of terminal voltage, improves. However, when a low-level signal is applied to the input terminal OE as stop signal, a current path is formed from the power source terminal VDD to ground GND through these pull-up resistors, which is not preferable from the standpoint of energy efficiency. Therefore, even from the standpoint of energy efficiency, it is preferable to disconnect the pull-up resistors Rpu1 to Rpum by turning OFF all the switches Swj of the delay circuit after the oscillator 40 is completed oscillating or reached a steady state.

### (2-4) Fourth Modified Embodiment

In the embodiments mentioned above, a plurality of capacitors or pull-up resistors whose connection/disconnection is controlled by switches, are connected in parallel in the delay circuit 15. However, the present invention is not limited to this case, and a plurality of capacitors or pull-up resistors whose connection/disconnection is controlled by switches, may be connected in series, instead.

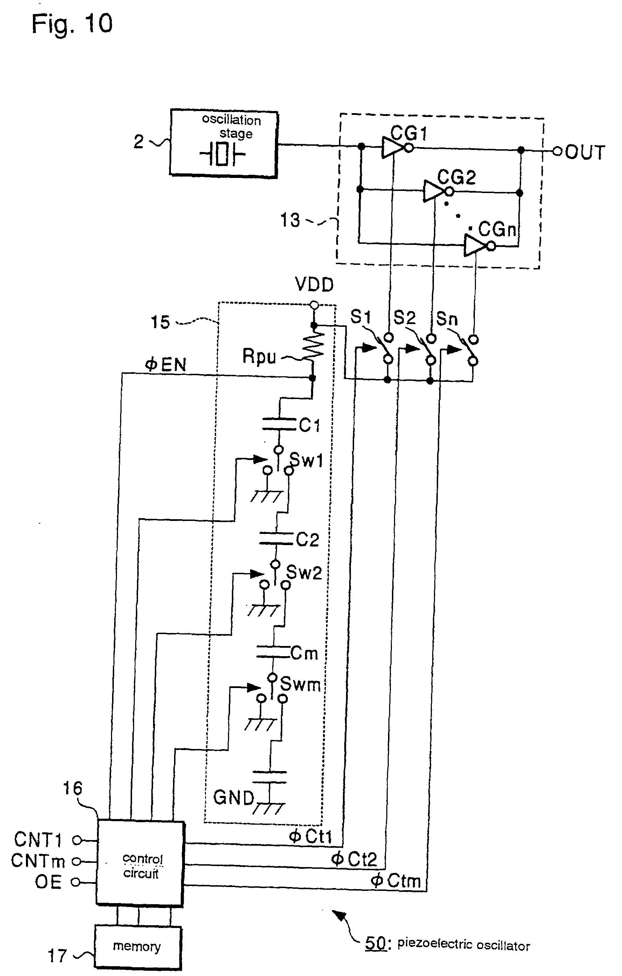

FIG. 10 is a block diagram of a piezoelectric oscillator 50 in which the delay circuit 15 is configured by connecting capacitors Cj (wherein j is 1, 2, ..., m) in series via changeover switches SWj connecting, under the control of control circuit 16, an associated capacitor either to another capacitor or to ground. As shown, capacitor C1 has one end connected to pull-up resistor Rpu and the other end connected to a movable contact of switch Sw1. Switch Sw1 connects capacitor C1 either to ground or to one end of capacitor C2. The other end of capacitor C2 is connected to a movable contact of switch Sw2 for connecting capacitor C2 either to ground or to capacitor C3. In this way a desirable number of capacitor/switch combinations may be connected in series. In this case, when the delay time of the start signal φEN is set to be long, the number of capacitors to be connected in series is reduced.

### (2-5) Fifth Modified Embodiment

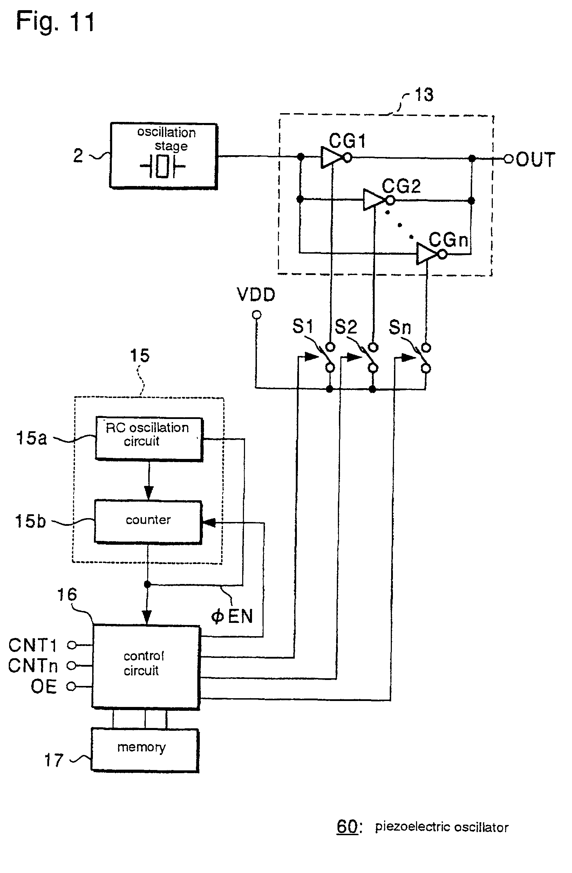

In the above-described embodiments, the delay time τ of the start signal φEN is set preferably by using the delay circuit 15, whose time constant varies depending on the connection state of a plurality of mechanical or electronic switches. However, the present invention is not limited to this case, and the delay circuit 15 may be made up of an oscillation circuit 15a and a counter 15b as shown in FIG. 11.

In other words, an RC oscillation circuit 15a generates pulses as soon as the power supply to the piezoelectric oscillator 60 is turned on, and the counter 15b counts these pulses. When the count value of the counter 15b reaches a pre-set value, high-level start signal φEN is output. In addition to its use for starting operation of the output stage 13, start signal φEN is also used here to stop operation of the RC oscillation circuit 15a. By changing the pre-set value of the counter 15b by means of the control circuit 16, the start delay time τ of the output stage 13 may be changed as desired.

Instead of using an extra RC oscillation circuit 15a pulses form the oscillation stage 2 may be counted by counter 15b instead. In this case, the counting operation of the counter 15b is stopped upon start signal φEN being output.

### (2-6) Sixth Modified Embodiment

The description of the above-noted embodiments did not mention the mounting conditions of the components of the respective oscillator. In each case, the oscillator can surely oscillate and provide pulses while lowering the power noise during the transient period after power supply was turned on, so that the elements, constituting the oscillator, can be integrated. For example, the whole circuit of the oscillator except for the resonator may be integrated (an integrated circuit), and provided in one ceramic package or a plastic package.

Therefore, the oscillator may be miniaturized and the number of parts can be reduced, thus reducing the assembly man-hours and manufacturing costs.

### (2-7) Seventh Embodiment

The above-mentioned embodiments of a piezoelectric oscillator can be broadly used for a variety of devices, such as a radio communication device and an electronic device.

An oscillator, which is built in a portable radio communication device, carries out intermittent oscillation during intermittent reception so as to save batteries, so that abnormal oscillations or no oscillation is usually a problem. Therefore, the oscillator according to the present invention is particularly suitable for a portable radio communication device.

## Claims

1. A piezoelectric oscillator comprising:
an oscillation stage (2) for generating pulses by exciting a piezoelectric resonator; and
an output stage (13) adapted to amplify the pulses and output the amplified pulses;
**characterized by** start delay means responsive to electric power to the oscillator being turned on and adapted to delay the start of operation of the output stage (13) relative to that of the oscillation stage (2) by a delay time which is selectable from a plurality of available delay times.

2. The oscillator according to Claim 1, wherein the start delay means comprises:
selection means (16, 17) for selecting one delay time from the plurality of delay times based on pre-set information;
delay means (15) for generating a start signal (φEN) gradually changing from a first level to a second level in accordance with the selected delay time; and
starting means (16, 17, S1-S3) for causing the output stage (13) to start in response to the start signal reaching its second level.

3. The oscillator according to Claim 1, wherein the start delay means comprises:
selection means (16A, 17) for selecting one delay time from the plurality of delay times based on pre-set information; and
delay means for generating a start signal (φEN) gradually changing from a first level to a second level in accordance with the selected delay time and for applying the start signal to the output stage (13);
wherein the output stages (13) is adapted to start operating in response to the start signal reaching its second level.

4. The oscillator according to Claim 2 or Claim 3, wherein the delay means comprises:
a resistance element (Rpu);
a plurality of capacitance elements (C1-C3); and
a plurality of switching means (Sw1-Sw3, Sw1-Swm) connected to the plurality of capacitance elements, respectively;
wherein the selection means (16, 17; 16A, 17) is adapted to select said delay time by controlling the plurality of switching means based on said pre-set information.

5. The oscillator according to Claim 2 or Claim 3, wherein the delay means comprises:
a capacitance element (C);
a plurality of resistance elements (Rpu1-Rpum); and
a plurality of switching means (Sw1-Swm) connected to the plurality of resistance elements, respectively;
wherein the selection means (16, 17) is adapted to select said delay time by controlling the plurality of switching means based on said pre-set information.

6. The oscillator according to Claim 5, wherein the switching means are transistors (Tr1-Trm), and the resistance elements are the ON resistances of the transistors.

7. The oscillator according to Claim 1, wherein the start delay means comprises:
selection means (16, 17) for selecting one delay time from the plurality of delay times based on pre-set information;
delay means (1 5) for generating a start signal (φEN) at a time delayed by the selected delay time from the start of oscillation of the oscillation stage (2); and
a starting means (S1-Sn) for causing the output stage (13) to start in response to the start signal.

8. The oscillator according to Claim 1, wherein the start delay means comprises:
selection means for selecting one delay time from the plurality of delay times based on pre-set information; and
delay means for generating a start signal at a time delayed by the selected delay time from the start of oscillation of the oscillation stage and for applying the start signal to the output stage;
wherein the output stage is adapted to start operating in response to the start signal.

9. The oscillator according to Claim 7 or Claim 8, wherein the delay means (15) comprises:
an oscillation circuit (2; 15a) for generating pulses; and
a counter (15b) for counting the pulses generated by said oscillation circuit and for outputting said start signal (φEN) when a predetermined number of pulses has been counted; wherein the selection means (16, 17) is adapted to set said predetermined number corresponding to the selected delay time based on said pre-set information.

10. The oscillator according to Claim 9, wherein the oscillation circuit is the oscillation stage (2).

11. The oscillator according to any of Claim 2 to Claim 7, wherein the output stage (13) comprises a plurality of clocked gates (CG1-CG3) connected in parallel; and wherein the starting means (S1-S3; S1-Sn) is adapted to cause the output stage (13) to start operating by operating predetermined clocked gates among the plurality of clocked gates based on pre-set information.

12. The oscillator according to any of Claim 2 to Claim 11, wherein the selection means (16, 17; 16A, 17) has input terminal means (CNT1, CNT2) for inputting information so as to renew said pre-set information to new set information as the new set information is input via the input terminal means.

13. The oscillator according to any of Claim 2, Claim 7 and Claim 11 wherein the starting means (S1-S3; S1-Sn) has a control input terminal (OE) and the output stage (13) is adapted to stop operating in response to a stop signal (φOE) being applied to the control input terminal.

14. The oscillator according to any of Claim 1 to Claim 13 wherein, except for a piezoelectric resonator, the circuit of the oscillator is integrated.

15. The oscillator according to Claim 14 wherein the oscillator is housed in one package.

16. An electronic device, having the oscillator according to any of Claim 1 to Claim 15, and operating based on the pulses (P) output from the oscillator.

## Patentansprüche

1. Piezoelektrischer Oszillator mit
einer Schwingstufe (2) zum Erzeugen von Impulsen durch Erregen eines piezoelektrischen Resonators; und einer Ausgangsstufe (13), die geeignet ist, die Impulse zu verstärken und die verstärkten Impulse abzugeben;
**gekennzeichnet durch** eine Startverzögerungseinrichtung, die auf das Einschalten elektrischen Stroms zum Oszillator anspricht und geeignet ist, den Start des Betriebs der Ausgangsstufe (13) im Verhältnis zu dem der Schwingstufe (2) um eine Verzögerungszeit zu verzögern, die aus einer Vielzahl verfügbarer Verzögerungszeiten auswählbar ist.

2. Oszillator nach Anspruch 1, bei dem die Startverzögerungseinrichtung folgendes aufweist:
eine Auswahleinrichtung (16, 17) zum Auswählen einer Verzögerungszeit aus der Vielzahl von Verzögerungszeiten auf der Basis voreingestellter Information;
eine Verzögerungseinrichtung (15) zum Erzeugen eines Startsignals (φEN), welches sich in Übereinstimmung mit der ausgewählten Verzögerungszeit allmählich von einem ersten Pegel zu einem zweiten Pegel ändert; und
eine Starteinrichtung (16, 17, S1-S3), die veranlaßt, daß die Ausgangsstufe (13) in Abhängigkeit davon, daß das Startsignal seinen zweiten Pegel erreicht, startet.

3. Oszillator nach Anspruch 1, bei dem die Startverzögerungseinrichtung folgendes aufweist:
eine Auswahleinrichtung (16A, 17) zum Auswählen einer Verzögerungszeit aus einer Vielzahl von Verzögerungszeiten auf der Basis voreingestellter Information; und
eine Verzögerungseinrichtung, die ein Startsignal (φEN)erzeugt, welches sich in Abhängigkeit von der ausgewählten Verzögerungszeit allmählich von einem ersten Pegel zu einem zweiten Pegel ändert, und die das Startsignal an die Ausgangsstufe (13) anlegt;
wobei die Ausgangsstufe geeignet ist, in Abhängigkeit davon, daß das Startsignal seinen zweiten Pegel erreicht, zu starten.

4. Oszillator nach Anspruch 2 oder 3, bei dem die Verzögerungseinrichtung folgendes aufweist:
ein Widerstandselement (Rpu);
eine Vielzahl von Kapazitätselementen (C1-C3); und
eine Vielzahl von Schalteinrichtungen (Sw1-Sw3, Sw1-Swm), die jeweils mit der Vielzahl der Kapazitätselemente verbunden sind;
wobei die Auswahleinrichtung (16, 17; 16A, 17) geeignet ist, die Verzögerungszeit durch Steuern der Vielzahl der Schaltelemente auf der Basis der voreingestellten Information auszuwählen.

5. Oszillator nach Anspruch 2 oder 3, bei dem die Verzögerungseinrichtung folgendes aufweist:
ein Kapazitätselement (C);
eine Vielzahl von Widerstandselementen (Rpu1-Rpum); und
eine Vielzahl von Schalteinrichtungen (Sw1-Swm), die jeweils mit der Vielzahl der Widerstandselemente verbunden sind;
wobei die Auswahleinrichtung (16, 17) geeignet ist, die Verzögerungszeit durch Steuern der Vielzahl der Schalteinrichtungen auf der Basis der voreingestellten Information auszuwählen.

6. Oszillator nach Anspruch 5, bei dem die Schalteinrichtungen Transistoren (Tr1-Trm) sind und die Widerstandselemente die Durchlaßwiderstände der Transistoren sind.

7. Oszillator nach Anspruch 1, bei dem die Startverzögerungseinrichtung folgendes aufweist:
eine Auswahleinrichtung (16, 17), die eine Verzögerungszeit aus der Vielzahl von Verzögerungszeiten auf der Basis voreingestellter Information auswählt;
eine Verzögerungseinrichtung (15), die ein Startsignal (φEN) zu einer Zeit erzeugt, die um die ausgewählte Verzögerungszeit ab Schwingungsbeginn der Schwingstufe (2) verzögert ist; und
eine Starteinrichtung (S1-Sn), die veranlaßt, daß die Ausgangsstufe (13) in Abhängigkeit von dem Startsignal startet.

8. Oszillator nach Anspruch 1, bei dem die Startverzögerungseinrichtung folgendes aufweist:
eine Auswahleinrichtung, die eine Verzögerungszeit aus der Vielzahl von Verzögerungszeiten auf der Basis voreingestellter Information auswählt; und
eine Verzögerungseinrichtung, die ein Startsignal zu einer Zeit erzeugt, die um die ausgewählte Verzögerungszeit ab Schwingungsbeginn der Schwingstufe verzögert ist, und die das Startsignal an die Ausgangsstufe anlegt,
wobei die Ausgangsstufe geeignet ist, in Abhängigkeit von dem Startsignal ihren Betrieb zu beginnen.

9. Oszillator nach Anspruch 7 oder 8, bei dem die Verzögerungseinrichtung (15) folgendes aufweist:
einen Schwingschaltkreis (2; 15a), der Impulse erzeugt; und
einen Zähler (15b), der die von dem Schwingschaltkreis erzeugten Impulse zählt und das Startsignal (φEN) abgibt, wenn eine vorherbestimmte Anzahl Impulse gezählt wurde; wobei die Auswahleinrichtung (16, 17) geeignet ist, die im voraus bestimmte Anzahl entsprechend der ausgewählten Verzögerungszeit auf der Basis der voreingestellten Information zu setzen.

10. Oszillator nach Anspruch 9, bei dem der Schwingschaltkreis die Schwingstufe (2) ist.

11. Oszillator nach einem der Ansprüche 2 bis 7, bei dem die Ausgangsstufe (13) eine Vielzahl parallelgeschalteter, getakteter Gatter (CG1-CG3) aufweist; und bei dem die Starteinrichtung (S1-S3; S1-Sn) geeignet ist, die Ausgangsstufe (13) zu veranlassen, ihren Betrieb zu beginnen, indem sie vorherbestimmte getaktete Gatter unter der Vielzahl getakteter Gatter auf der Basis von voreingestellter Information betätigt.

12. Oszillator nach einem der Ansprüche 2 bis 11, bei dem die Auswahleinrichtung (16, 17; 16A, 17) Eingangsanschlußeinrichtungen (CNT1, CNT2) zur Eingabe von Information hat, um die voreingestellte Information auf neu eingestellte Information zu erneuern, wenn die neu eingestellte Information über die Eingangsanschlußeinrichtungen eingegeben wird.

13. Oszillator nach einem der Ansprüche 2, 7 und 11, bei dem die Starteinrichtung (S1-S3; S1-Sn) einen Steuereingangsanschluß (OE) hat und die Ausgangsstufe (13) geeignet ist, ihren Betrieb in Abhängigkeit davon, daß ein Stopsignal (φOE) an den Steuereingangsanschluß angelegt wird, anzuhalten.

14. Oszillator nach einem der Ansprüche 1 bis 13, bei dem der Schaltkreis des Oszillators mit Ausnahme eines piezoelektrischen Resonators integriert ist.

15. Oszillator nach Anspruch 14, bei dem der Oszillator in einem einzigen Gehäuse untergebracht ist.

16. Elektronisches Gerät, welches den Oszillator gemäß einem der Ansprüche 1 bis 15 hat und auf der Basis der vom Oszillator abgegebenen Impulse (P) arbeitet.

## Revendications

1. Oscillateur piézoélectrique comprenant :
un étage d'oscillation (2) destiné à produire des impulsions en excitant un résonateur piézoélectrique ; et
un étage (13) de sortie conçu pour amplifier les impulsions et fournir en sortie les impulsions amplifiées ;
**caractérisé par** des moyens à retard de déclenchement sensibles au fait que l'alimentation électrique de l'oscillateur est activée et conçus pour retarder le déclenchement du fonctionnement de l'étage de sortie (13) par rapport à celui de l'étage d'oscillation (2) d'un temps de retard qui peut être sélectionné parmi une pluralité de temps de retard disponibles.

2. Oscillateur suivant la revendication 1, dans lequel les moyens à retard de déclenchement comprennent :
des moyens (16, 17) de sélection destinés à sélectionner un temps de retard parmi la pluralité de temps de retard sur la base d'informations définies à l'avance ;
des moyens (15) à retard destinés à produire un signal de déclenchement (φEN) passant progressivement d'un premier niveau à un deuxième niveau en fonction du temps de retard sélectionné ; et
des moyens de déclenchement (16, 17, S1-S3) destinés à faire en sorte que l'étage (13) de sortie soit déclenché en réponse au fait que le signal de déclenchement atteint son deuxième niveau.

3. Oscillateur suivant la revendication 1, dans lequel les moyens à retard de déclenchement comprennent :
des moyens (16A, 17) de sélection destinés à sélectionner un temps de retard parmi la pluralité de temps de retard sur la base d'informations définies à l'avance et
des moyens à retard destinés à produire un signal de déclenchement (φEN) passant progressivement d'un premier niveau à un deuxième niveau en fonction du temps de retard sélectionné et à appliquer le signal de déclenchement à l'étage (13) de sortie ;
dans lequel (13) l'étage de sortie est conçu pour commencer à fonctionner en réponse au fait que le signal de déclenchement atteint son deuxième niveau.

4. Oscillateur suivant la revendication 2 ou la revendication 3, dans lequel les moyens à retard comprennent :
un élément de résistance (Rpu) ;
une pluralité d'éléments de capacité (C1-C3) ; et
une pluralité d'éléments de commutation (Sw1-Sw3, Sw1-Swm) respectivement connectés à la pluralité d'éléments de capacité ;
dans lequel les moyens (16, 17 ; 16A, 17) de sélection sont conçus pour sélectionner ledit temps de retard en commandant la pluralité de moyens de commutation sur la base des informations définies à l'avance.

5. Oscillateur suivant la revendication 2 ou la revendication 3, dans lequel les moyens à retard comprennent :
un élément de capacité (C) ;
une pluralité d'éléments de résistance (Rpu1, Rpum) ; et
une pluralité d'éléments de commutation (Sw1-Swm) respectivement connectés à la pluralité d'éléments de résistance ;
dans lequel les moyens (16, 17) de sélection sont conçus pour sélectionner ledit temps de retard en commandant la pluralité de moyens de commutation sur la base des informations définies à l'avance.

6. Oscillateur suivant la revendication 5, dans lequel les moyens de commutation sont des transistors (Tr1-Trm) et les éléments de résistance sont les résistances à l'état passant des transistors.

7. Oscillateur suivant la revendication 1, dans lequel les moyens à retard de déclenchement comprennent :
des moyens (16, 17) de sélection pour sélectionner un temps de retard parmi la pluralité de temps de retard sur la base d'informations définies à l'avance ;
des moyens (15) à retard destinés à produire un signal de déclenchement (φEN) à un instant retardé du temps de retard sélectionné par rapport au début de l'oscillation de l'étage d'oscillation (2) ; et
des moyens (S1-Sn) de déclenchement pour faire en sorte que l'étage de sortie (13) soit déclenché en réponse au signal de déclenchement.

8. Oscillateur suivant la revendication 1, dans lequel les moyens à retard de déclenchement comprennent :
des moyens de sélection pour sélectionner un temps de retard parmi la pluralité de temps de retard sur la base d'informations définies à l'avance ; et
des moyens à retard destinés à produire un signal de déclenchement à un instant retardé du temps de retard sélectionné par rapport au déclenchement de l'oscillation de l'étage d'oscillation et à appliquer le signal de déclenchement à l'étage de sortie ;
dans lequel l'étage de sortie est conçu pour commencer à fonctionner en réponse au signal de déclenchement.

9. Oscillateur suivant la revendication 7 ou la revendication 8, dans lequel les moyens (15) à retard comprennent :
un circuit (2 ; 15a) d'oscillation destiné à produire des impulsions ; et
un compteur (15b) destiné à compter les impulsions produites par le circuit d'oscillation et à fournir en sortie le signal de déclenchement (φEN) lorsqu'un nombre déterminé à l'avance d'impulsions a été compté ;
dans lequel les moyens (16, 17) de sélection sont conçus pour fixer le nombre déterminé à l'avance correspondant au temps de retard sélectionné sur la base des informations définies à l'avance.

10. Oscillateur suivant la revendication 9, dans lequel le circuit d'oscillation est l'étage (2) d'oscillation.

11. Oscillateur suivant l'une quelconque des revendications 2 à 7, dans lequel l'étage (13) de sortie comprend une pluralité de portes cadencées (CG1-CG3) connectées en parallèle ; et dans lequel les moyens de déclenchement (S1-S3 ; S1-Sn) sont conçus pour faire en sorte que l'étage (13) de sortie commence à fonctionner en faisant fonctionner des portes cadencées déterminées à l'avance parmi la pluralité de portes cadencées sur la base d'informations définies à l'avance.

12. Oscillateur suivant l'une quelconque des revendications 2 à 11, dans lequel les moyens (16, 17 ; 16A, 17) de sélection comportent des moyens (CNT1, CNT2) à bornes d'entrée destinés à fournir en entrée des informations afin de renouveler les informations définies à l'avance en de nouvelles informations définies, lorsque les nouvelles informations définies sont fournies en entrée par l'intermédiaire des moyens à bornes d'entrée.

13. Oscillateur suivant l'une quelconque des revendications 2, 7 et 11, dans lequel les moyens de déclenchement (S1-S3 ; S1-Sn) comportent une borne (OE) d'entrée de commande et l'étage (13) de sortie est conçu pour cesser de fonctionner en réponse au fait qu'un signal (φOE) d'arrêt est appliqué à la borne d'entrée de commande.

14. Oscillateur suivant l'une quelconque des revendications 1 à 13, dans lequel, à l'exception d'un résonateur piézoélectrique, le circuit de l'oscillateur est intégré.

15. Oscillateur suivant la revendication 14, dans lequel l'oscillateur est logé dans un boîtier.

16. Dispositif électronique comportant l'oscillateur suivant l'une quelconque des revendications 1 à 15, et fonctionnant sur la base des impulsions (P) fournies en sortie par l'oscillateur.
